Europäisches Patentamt

European Patent Office

Office européen des brevets

(19)

(11) Numéro de publication : **0 172 769**
**B1**

(12) **FASCICULE DE BREVET EUROPÉEN**

(45) Date de publication du fascicule du brevet :
19.10.88

(51) Int. Cl.⁴ : **H 05 K   5/06**, H 03 H   9/10

(21) Numéro de dépôt : 85401523.7

(22) Date de dépôt : 23.07.85

(54) Boîtier à fermeture à froid supportant les hautes températures.

(30) Priorité : 27.07.84 FR 8411969

(43) Date de publication de la demande :
26.02.86 Bulletin 86/09

(45) Mention de la délivrance du brevet :
19.10.88 Bulletin 88/42

(84) Etats contractants désignés :
CH DE GB IT LI LU NL SE

(56) Documents cités :
EP-A- 0 018 250
DE-A- 2 239 685
FR-A- 1 113 719
FR-A- 1 347 121
US-A- 2 301 269
US-A- 4 453 104

(73) Titulaire : COMPAGNIE D'ELECTRONIQUE ET DE PIE-
ZO-ELECTRICITE - C.E.P.E.
44, rue de la Glacière
F-95100 Argenteuil (FR)

(72) Inventeur : Debaisieux, André
THOMSON-CSF SCPI 173, bld Haussmann
F-75379 Paris Cedex 08 (FR)
Inventeur : Aubry, Jean-Pierre
THOMSON-CSF SCPI 173, bld Haussmann
F-75379 Paris Cedex 08 (FR)

(74) Mandataire : Ruellan-Lemonnier, Brigitte et al
THOMSON-CSF SCPI 19, avenue de Messine
F-75008 Paris (FR)

EP 0 172 769 B1

## Description

La présente invention se rapporte au domaine connu dans la technique sous le nom d'encapsulation. Cette notion concerne la protection, contre les causes de dégradation diverses dues à l'environnement, de dispositifs tels que, par exemple, des circuits intégrés à l'état solide, des relais électro-mécaniques, des résonateurs piézoélectriques.

Deux causes principales de dégradation sont constatées en pratique, l'une liée à des phénomènes de corrosion chimique-oxydation par l'oxygène de l'air — atmosphères acides ou basiques air salin — l'autre à la vapeur d'eau.

Dans tous les cas, la solution du problème est obtenue en enfermant le dispositif à protéger dans une enceinte étanche, qui est habituellement désignée sous le nom de boîtier.

De plus, le choix de l'atmosphère gazeuse intérieure étant librement déterminable, on peut alors effectuer un remplissage de gaz chimiquement neutre tel que l'azote, l'hélium, ou un mélange hélium-néon. Dans certaines applications, telles que les tubes électroniques par exemple, on peut même créer un vide élevé, de l'ordre de $10^{-6}$ mm de mercure.

Pour la réalisation pratique des boîtiers, il a été fait jusqu'à maintenant appel soit à un métal, soit à un verre, un boîtier étant, dans l'un ou l'autre cas, constitué par la réunion et la soudure d'un capot sur une embase, après avoir fixé le dispositif à encapsuler sur celle-ci.

Ainsi on connaît par DE-A-2 239 685 un boîtier étanche dont l'embase comprend une coupelle et une platine métallique et dont le capot est muni d'une collerette, l'embrase et le capot étant réalisés de manière à permettre par leur mise en contact l'encapsulation de l'élément à protéger. L'embase comprend des perçages permettant l'introduction de broches solidaires de la platine, isolées par rapport à celle-ci et assurant des connexions électriques avec l'élément à protéger. Une broche de masse est brasée sur la coupelle.

Cependant, il a été constaté que, au cours de l'utilisation du dispositif ainsi encapsulé, la composition de l'atmosphère intérieure évolue avec le temps, des impuretés telles que des traces de l'air ambiant lors de la fermeture, et de vapeur d'eau, se dégageant progressivement. Ces impuretés sont retenues sur la face interne des boîtiers par les phénomènes de l'absorption et de l'adsorption, dans des proportions beaucoup plus importantes pour les surfaces métalliques que pour les surfaces de verre par exemple.

En pratique, cependant, malgré les avantages présentés par les boîtiers de verre, on met le plus souvent en œuvre dans l'industrie les boîtiers de métal de bonne soudabilité, cuivre ou acier, recouverts de couches de métaux peu oxydables, tels que le nickel, l'or ou une succession des deux, soit le maillechort, alliage de cuivre, de nickel et de zinc, où l'on a maintenu une faible teneur de ce dernier métal.

Par rapport aux dispositifs de l'art connu, le boîtier de l'invention présente de nombreux avantages notamment :
— celui de résister à de hautes températures,
— celui d'être fermé par fermeture à froid ce qui permet de n'entraîner aucune contrainte lors de celle-ci.

L'invention a pour objet un boîtier hermétique comportant une embase et un capot muni d'une collerette, l'embase et le capot permettant par leur mise en contact une fermeture pour obtenir l'encapsulation d'un élément à protéger, l'embase comportant au moins deux perçages dans lesquels sont introduites des broches destinées à assurer les connexions électriques avec ledit élément, l'embase comprenant une coupelle et une platine métallique, les broches étant solidaires de ladite platine et isolées par rapport à celle-ci, une broche de masse étant brasée sur la coupelle, caractérisé en ce que le boîtier comporte au moins deux colonnes internes au capot et solidaires de la platine de manière à suspendre ledit élément à protéger, en ce que les matériaux constituant le boîtier sont choisis afin de résister à des températures supérieures à 300 °C et en ce que la fermeture est réalisée à froid.

L'invention sera mieux comprise à la lecture de la description qui va suivre, donnée à titre non limitatif, en relation avec les dessins annexés qui représentent :
— la figure 1, un boîtier selon l'invention en vue de dessous ;
— la figure 2, une vue en coupe du boîtier selon l'invention ;
— la figure 3, un élément du boîtier selon l'invention ;
— les figures 4 et 5, deux exemples de réalisation du boîtier selon l'invention.

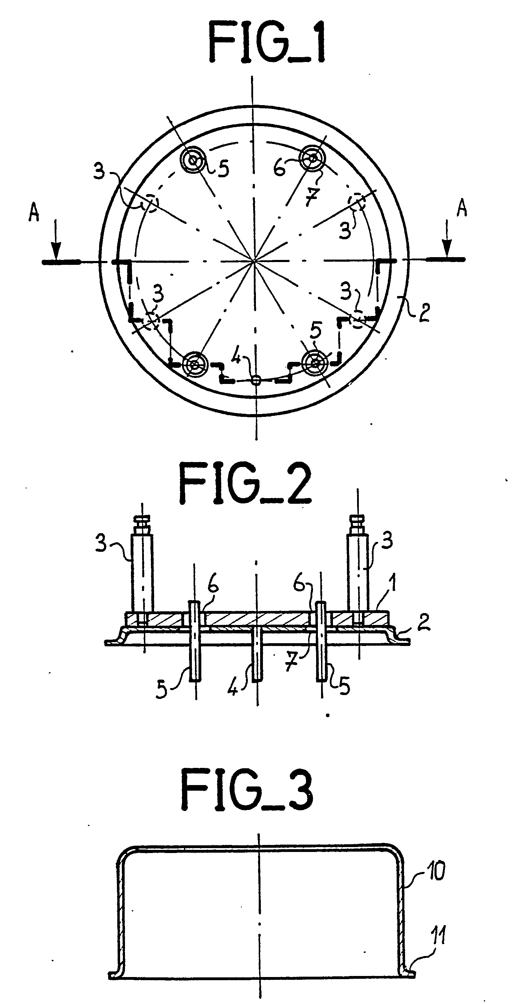

L'invention est donc illustré aux figures 1 et 2 ; où la figure 1 est une vue de dessous du boîtier et la figure 2 en vue en coupe selon la coupe AA représentée en figure 1.

Le boîtier selon l'invention comporte une embase et un capot 10.

Cette embase est constituée de :
— une coupelle 2 emboutie,
— une platine 1 métallique.

La coupelle 2 et la platine 1 sont reliées entre elles par une brasure où tout autre procédé permet d'obtenir une liaison de qualité.

Dans l'ensemble ainsi constitué, on réalise des perçages destinés à recevoir des broches 5 assurant les connexions électriques.

L'isolation électrique est assurée par exemple par des billes de verre 6 serties à chaud, ou par tout autre matériau isolant scellé par tout autre procédé. L'enverrage s'effectue dans la platine 1.

Il est d'ailleurs possible d'effectuer un enverrage global de l'intérieur de la coupelle 2.

Ainsi à la figure 2, les connexions 5 se présentent sous la forme de broches dont chacune est maintenue en position par une traversée isolante 6. On utilise classiquement à cet effet une perle de verre. Chaque broche 5 présente une partie dépassant à l'extérieur du boîtier et une partie dépassant à l'intérieur du boîtier destinée à la soudure d'un fil de connexion du ou des circuits dont doit être muni le boîtier.

Le nombre des connexions peut être variable mais au moins égal à deux.

Dans la platine 1 métallique, on dispose au moins deux colonnes 3 métalliques destinées à assurer diverses fonctions en rapport avec l'utilisation du boîtier et notamment de permettre la suspension de l'élément interne au boîtier qui peut être par exemple un résonateur.

La liaison colonne 3-platine 1 est assurée par brasage ou tout autre procédé.

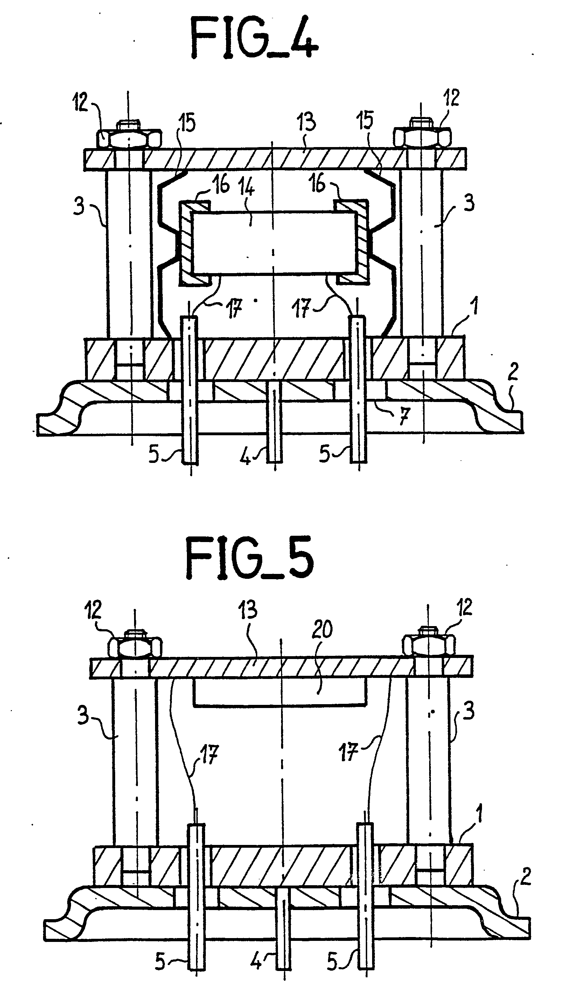

Le capot 10 représenté en figure 3 est obtenu par emboutissage ou tout autre procédé permettant son obtention.

Ce capot 10 possède une collerette 11 métallique de dimension variable.

L'épaisseur du matériau utilisé est fonction des dimensions du capot 10 et des conditions d'utilisation.

La fermeture capot 10 — embase peut être assurée par soudure à froid ou électrique ou tout autre procédé permettant d'assurer une parfaite étanchéité à un vide inférieur ou égal à quelques $133,32 \times 10^{-6}$ Pa ($10^{-6}$ Torr).

L'ensemble doit être en mesure de résister à des variations de température importantes, les matériaux devant être choisis afin de résister à des températures supérieures à 300 °C.

Ainsi, le boîtier de l'invention comporte des perles de verre 6 prises dans la platine métallique 1 et non pas dans la coupelle 2 de fermeture qui correspondent à autant de pattes ou broches 5.

Il comporte aussi au moins deux colonnes 3.

La fermeture du boîtier est par exemple une fermeture Coldweld à froid qui est réalisée entre les collerettes que comportent la coupelle 2 et le capot 10. EP-A-0 018 250 mentionne la possibilité d'une fermeture à froid pour rendre solidaire l'embase et le capot d'un boîtier d'encapsulation pour composant électronique (page 5, lignes 1-5). US-A-4 453 104 mentionne également cette technique pour un boîtier d'encapsulation d'un quartz. Une fermeture à froid consiste en un écrasement à froid de deux métaux par fluage et donc par interpénétration des molécules de ces deux matériaux ce qui permet d'obtenir une fermeture étanche très efficace. De plus, cette fermeture ne permet pas une ouverture sans destruction du boîtier. La platine est brasée sur la coupelle.

Les perles de verre 6 sont coulées dans la platine. Le boîtier de l'invention peut fonctionner à des températures telles que 420 °C, 430 °C sans qu'il n'y ait décollage de ces enverrages au niveau de la platine. Pour ce faire, le type de verre employé et le matériau de la platine sont choisis pour avoir des coefficients de dilatation voisins pour des températures variant de 0 à 450 °C.

Ce boîtier est fermé par exemple dans une enceinte sous vide à une température supérieure à la température ambiante ce qui permet d'améliorer le vide par effet getter lors du refroidissement ultérieur. De plus, il n'y a plus besoin de queusot de pompage qui entraînait une dégradation du vide à l'intérieur du boîtier.

Si l'on considère les réalisations illustrées aux figures 4 et 5, le boîtier de l'invention comporte donc une coupelle 2 et un capot 10. Il comporte en outre au moins une platine 1, cette platine étant une platine inférieure, mais il peut aussi comporter une platine supérieure 13, rendue solidaire des colonnes métalliques 3 par exemple par des moyens de maintien 12, de soutien d'un circuit électronique 20, hybride par exemple, ou qui permet la suspension d'un résonateur 14 par l'intermédiaire de ressorts 15. Ce résonateur peut être un quartz de type « BVA », c'est-à-dire de type « Boîtier à vieillissement amélioré » ou de type « QAS », c'est-à-dire « quartz auto-suspendu ». Il comporte aussi une sortie de masse 4 brasée dans la coupelle dont la position importe peu.

Ainsi, on peut considérer un pas des différentes broches du boîtier tel que celui-ci soit compatible avec celui d'un circuit imprimé pour qu'il y ait ainsi, possibilité de connexion directe.

La platine 1 a une rigidité supérieure à celle de la coupelle 2 brasée ce qui permet d'éviter l'apparition de toute contrainte au niveau de la platine 1 lors de la fermeture du boîtier.

Le boîtier peut contenir un circuit électrique 20, réalisé en technologie hybride par exemple, qui peut être par exemple un oscillateur complet encapsulé sous vide ce qui permet d'obtenir une diminution de consommation. Cet oscillateur comprend alors un quartz encapsulé ou non.

Le capot 10 peut être réalisé par exemple en nickel, en cuivre nickelé, en aluminium traité ou tout autre matériau susceptible d'accepter une fermeture à froid étanche.

L'embase comporte donc une coupelle 2 en un matériau analogue à celui du capot pour permettre une fermeture à froid étanche, et une platine 1 qui peut être en acier par exemple Inox ou aciers spéciaux ou de tout autre matériau possédant un coefficient de dilatation voisin de celui des perles de verre 6 sur une large gamme de température.

La brasure entre la platine 1 et la coupelle 2 est une brasure haute température permettant de fonctionner à des températures supérieures à 450 °C.

Les perles de verre 6 peuvent être un scellement Diuver ferro-nickel, ou en verre au molybdène, ou en verre 740 par exemple ou de tous matériaux compatibles qui tiennent jusqu'à des températures d'environ 540 °C.

Pour éviter que le boîtier ne s'écrouisse naturellement dans le temps, c'est-à-dire que la matière ne se durcisse superficiellement en surface, ce qui entraînerait, du fait de la fermeture et aux endroits en contact, l'apparition de microfissures dans le temps, un dépôt d'or fin est effectué en surface. Ainsi le boîtier est protégé contre toute agression chimique.

On peut obtenir un vide à l'intérieur du boîtier inférieur à 10⁻⁷ Torr avec un dégazage pour une température supérieure à 350 °C.

Après avoir réalisé le vide à l'intérieur du boîtier, on peut remplir ce boîtier d'un gaz neutre tel que l'hélium par exemple ce qui permet d'améliorer les paramètres thermiques ou d'un gaz « pureté électronique » tel que le Silane par exemple qui est une combinaison de gaz neutres.

Le boîtier de l'invention présente ainsi de nombreux avantages notamment :
— celui de résister à de hautes températures,
— celui d'être fermé par fermeture à froid ce qui permet de n'entraîner aucune contrainte au niveau de la platine.

**Revendications**

1. Boîtier hermétique comportant une embase et un capot (10) muni d'une collerette (11), l'embase et le capot permettant par leur mise en contact une fermeture pour obtenir l'encapsulation d'un élément à protéger, l'embase comportant au moins deux perçages dans lesquels sont introduites des broches (5) destinées à assurer les connexions électriques avec ledit élément, l'embase comprenant une coupelle (2) et une platine métallique (1), les broches étant solidaires de ladite platine (1) et isolées par rapport à celle-ci, une broche de masse (4) étant brasée sur la coupelle, caractérisé en ce que le boîtier comporte au moins deux colonnes (3) internes au capot (10) et solidaires de la platine (1) de manière à suspendre ledit élément à protéger, en ce que les matériaux constituant le boîtier sont choisis afin de résister à des températures supérieures à 300 °C et en ce que la fermeture est réalisée à froid.

2. Boîtier selon la revendication 1, caractérisé en ce que les broches (5) sont isolées par rapport à la platine (1) par des perles de verre (6).

3. Boîtier selon la revendication 1, caractérisé en ce que la coupelle (2) et la platine (1) sont reliées entre elles par une brasure.

4. Boîtier selon la revendication 1, caractérisé en ce que la coupelle (2) est une coupelle emboutie.

5. Boîtier selon la revendication 1, caractérisé en ce que le matériau de la platine et les perles de verre ont des coefficients de dilatation voisins pour des températures variant de 0 à 450 °C.

6. Boîtier selon la revendication 1, caractérisé en ce que le capot (10) est réalisé en un matériau pris parmi les matériaux suivants : nickel, cuivre nickelé, aluminium traité.

7. Boîtier selon la revendication 6, caractérisé en ce que la coupelle (2) est réalisée en un matériau analogue à celui du capot (10).

8. Boîtier selon la revendication 1, caractérisé en ce que la platine (1) est réalisée en un matériau pris parmi les matériaux suivants : inox ou aciers spéciaux.

9. Boîtier selon la revendication 1, caractérisé en ce que les perles de verre (6) sont réalisées en un matériau pris parmi les matériaux suivants : verre scellement ferro-nickel ou verre au molybdène.

10. Boîtier selon la revendication 1, caractérisé en ce qu'il comporte un dépôt d'or fin à sa surface.

11. Boîtier selon la revendication 1, caractérisé en ce qu'il contient un gaz neutre.

12. Boîtier selon la revendication 1, caractérisé en ce qu'il contient une combinaison de gaz neutres.

**Claims**

1. A hermetic enclosure comprising a base and a cap (10) provided with a collar (12), said base and said cap permitting, when placed in contact, the closure of the enclosure for the encapsulation of an element to be protected, said base comprising at least two holes into which the pins (5) are introduced intended to ensure the electrical connections with the said element, the base comprising a cup (2) and a metallic plate (1), said pins being integral with said plate (1) and insulated therefrom, a ground pin (4) being soldered on the cup, characterized in that the enclosure comprises at least two columns (3) internal of the cap (10) and integral with the plate (1) in such a manner as to suspend the said element to be protected, in that the materials constituting the enclosure are selected in order to resist temperatures in excess of 300 °C and in that the closure is produced while the structure is cold.

2. The enclosure as claimed in claim 1, characterized in that the pins (5) are insulated in relation to the plate (1) by beads of glass (6).

3. The enclosure as claimed in claim 1, characterized in that the cup (2) and the plate (1) are connected with each other by brazing.

4. The enclosure as claimed in claim 1, characterized in that the cup (2) is an inserted cup.

5. The enclosure as claimed in claim 1, characterized in that the materials of the plate and the beads of glass have coefficients of expansion similar to each other at temperatures between 0 and 450 °C.

6. The enclosure as claimed in claim 1, characterized in that the cap (10) is made of a material selected from the following : nickel, nickel plated copper and treated aluminum.

7. The enclosure as claimed in claim 6, characterized in that the cup (2) is made of a material similar to that of the cap (10).

8. The enclosure as claimed in claim 1, characterized in that the plate (1) is made of a material selected from the following materials : stainless steel or special-purpose steels.

9. The enclosure as claimed in claim 1, characterized in that the beads of glass (6) are made of a material selected from the following materials : ferro-nickel sealing glass or molybdenum glass.

10. The enclosure as claimed in claim 1, characterized in that it comprises a deposit of fine gold on its surface.

11. The enclosure as claimed in claim 1, characterized in that it contains a neutral gas.

12. The enclosure as claimed in claim 1, characterized in that it contains a combination of neutral gases.

**Patentansprüche**

1. Hermetisches Gehäuse mit einem Sockel und einer mit einem Kragen (11) versehenen Haube (10), wobei der Sockel und die Haube durch Herstellen ihrer Berührung miteinander einen Verschluß für die Verkapselung eines zu schützenden Elementes ermöglichen, wobei der Sockel wenigstens zwei Durchlässe aufweist, in welche Stifte (5) eingeführt werden, die dazu geeignet sind, die elektrischen Verbindungen mit dem genannten Element zu gewährleisten, wobei der Sockel eine Schale (2) sowie eine Metallplatte (1) umfaßt, die Stifte mit der genannten Platte (1) fest verbunden und in Bezug auf diese isoliert sind, und wobei ein Massestift (4) auf der Schale angelötet ist, dadurch gekennzeichnet, daß das Gehäuse wenigstens zwei in Bezug auf die Haube (10) innere Stützen (3) aufweist, die mit der Platte (11) fest verbunden sind, so daß das zu schützende Element aufgehängt wird, daß die das Gehäuse bildenden Stofte derart ausgewählt sind, daß sie Temperaturen von über 300 °C widerstehen, und daß der Verschluß kalt verwirklicht wird.

2. Gehäuse nach Anspruch 1, dadurch gekennzeichnet, daß die Stifte (5) durch Glasperlen (6) in Bezug auf die Platte (1) isoliert sind.

3. Gehäuse nach Anspruch 1, dadurch gekennzeichnet, daß die Schale (2) und die Platte (1) durch ein Hartlot miteinander verbunden sind.

4. Gehäuse nach Anspruch 1, dadurch gekennzeichnet, daß die Schale (1) eine geprägte Schale ist.

5. Gehäuse nach Anspruch 1, dadurch gekennzeichnet, daß der Stoff der Platte sowie die Glasperlen benachbarte Wärmeausdehnungskoeffiziente für zwischen 0 bis 450 °C schwankende Temperaturen haben.

6. Gehäuse nach Anspruch 1, dadurch gekennzeichznet, daß die Haube (10) aus einem Stoff gebildet wird, der aus den folgenden Stoffen gewählt ist : Nickel, Nickelkupfer, verarbeitetes Aluminium.

7. Gehäuse nach Anspruch 6, dadurch gekennzeichnet, daß die Schale (2) aus einem Stoff gebildet wird, der demjenigen der Haube (10) ähnlich ist.

8. Gehäuse nach Anspruch 1, dadurch gekennzeichnet, daß die Platte (1) aus einem Stoff gebildet wird, der zwischen folgenden Stoffen gewählt ist : Inox oder Spezial-Stähle.

9. Gehäuse nach Anspruch 1, dadurch gekennzeichnet, daß die Glasperlen (6) aus einem Stoff gebildet werden, der aus den folgenden Stoffen gewählt ist : Ferro-Nickel-Glasverbindung oder Molybdän-Glas.

10. Gehäuse nach Anspruch 1, dadurch gekennzeichnet, daß es an seiner Oberfläche einen Feingold-Überzug aufweist.

11. Gehäuse nach Anspruch 1, dadurch gekennzeichnet, daß es ein neutrales Gas beinhaltet.

12. Gehäuse nach Anspruch 1, dadurch gekennzeichnet, daß es eine Zusammensetzung aus neutralen Gasen beinhaltet.

# FIG_1

# FIG_2

# FIG_3

# FIG_4

# FIG_5